Europäisches Patentamt

European Patent Office

Office européen des brevets

(11) Publication number: **0 056 482**
**B1**

## EUROPEAN PATENT SPECIFICATION

(45) Date of publication of patent specification: **09.04.86**

(51) Int. Cl.⁴: **H 01 L 21/316, H 01 L 23/28**

(21) Application number: **81110699.6**

(22) Date of filing: **22.12.81**

(54) **Glass passivation semiconductor device and method of manufacturing the same.**

(30) Priority: **17.01.81 JP 4613/81**

(43) Date of publication of application:
**28.07.82 Bulletin 82/30**

(45) Publication of the grant of the patent:
**09.04.86 Bulletin 86/15**

(84) Designated Contracting States:
**DE GB NL**

(56) References cited:
**GB-A-2 003 662**
**US-A-3 632 434**

(73) Proprietor: **Kabushiki Kaisha Toshiba
72, Horikawa-cho Saiwai-ku
Kawasaki-shi Kanagawa-ken 210 (JP)**

(72) Inventor: **Tani, Keizo
40 Saitobuncho
Kanagawa-ku Yokohama-shi (JP)**
Inventor: **Hideshima, Makoto
87-47, Hisamoto
Takatsu-ku Kawasaki-shi (JP)**
Inventor: **Shimbo, Masaru
4312-10, Izumi-cho
Totsuka-ku Yokohama-shi (JP)**
Inventor: **Miyagawa, Masafumi
1-11-32, Kamiitouzu Kokurakita-ku
Katakyushu-shi, Fukuoka-ken (JP)**

(74) Representative: **Henkel, Feiler, Hänzel & Partner
Möhlstrasse 37
D-8000 München 80 (DE)**

## Description

The present invention relates to a high voltage withstanding glass passivation semiconductor device and a method of manufacturing the same.

There are conventionally well known high voltage withstanding semiconductor devices of beveled structure and of guard ring structure. However, the semiconductor device of beveled structure is poor in damp-proofness because the film for protecting its junction surface is made of organic material such as silicone. In addition, it is liable to cause leakage current according to the high temperature bias test. It is therefore lack of reliability. On the other hand, the semiconductor device of guard ring structure is liable to deteriorate its characteristic because $SiO_2$ film which is used as the protection film for stabilizing the surface of semiconductor elements is so thin as to cause electric field to have its effect even outside $SiO_2$ film.

A high voltage withstanding semiconductor device which uses glass material as the passivation film so as to eliminate above-mentioned drawbacks (hereinafter referred to as "glass passivation semiconductor device") has been put to practical use these days. An example of this device is disclosed in the Japanese Patent Publication (Kokoku) No. 42668/78.

This glass passivation semiconductor device is usually manufactured by 1) chemically mesa-etching the junction formed in a semiconductor substrate or cutting the junction in parallel crosses by a diamond blade to form a recess, 2) filling glass material in the etched region or recess according to electrophoresis method, for example, and 3) sintering glass material filled. The glass passivation semiconductor device thus manufactured has higher reliability than conventional high voltage withstanding semiconductor devices as already mentioned above.

In the case of this glass passivation semiconductor device, however, internal stress is generated in the semiconductor substrate causing the semiconductor substrate to be bent in concave because coefficient of thermal expansion of glass material filled in the recess or etched region is different from that of semiconductor substrate. The semiconductor substrate or wafer therefore breaks and cracks are caused in glass material in the subsequent photoetching process. In addition, glass or pellet cracks are easily caused even in the semiconductor device or pellet having no glass crack in the assembly after the dicing or scribing process. The semiconductor device having glass or pellet cracks is poor in dielectric strength. The yield of glass passivation semiconductor devices conventionally manufactured is low accordingly.

Document GB—A—2 003 662 discloses a method for stabilizing the surface treatment of a semiconductor body. In this method, recesses are intersected in PN junction surfaces, and after cleaning the semiconductor surface by etching a thin layer of the oxide of the semiconductor material and three further sublayers of a glass having decreasing thermal expansion coefficients are formed one after another in the recesses so as to avoid cracks in the entire glass coat. This method does not use a surface stabilizing protection film, and the three glass sublayers having two different thermal expansion coefficient result in a complicated structure.

The object of the present invention is to provide a glass passivation semiconductor device capable of preventing cracks from being caused in the passivation glass.

This object of the present invention is achieved by a glass passivation semiconductor device comprising a PN junction region formed by first and second semiconductor regions, a passivation glass directly formed on said PN junction and a stress relaxing layer formed on said passivation glass, said semiconductor device being characterized in that a surface stabilizing protection film covers at least one of said first and second semiconductor regions, and said stress relaxing layer is tightly contacted with said protection film so as to relax stress in said passivation glass.

The stress relaxation layer covers the surface stabilizing and protecting film formed on the surface of semiconductor substrate.

The glass passivation semiconductor device thus manufactured causes almost no glass crack to thereby enhance the yield thereof. The glass passivation semiconductor device is therefore suitable for mass production.

Other objects and advantages of the present invention will become apparent from the following detailed description when taken in conjunction with the accompanying drawings, in which:

Fig. 1 is a sectional view showing the conventional glass passivation semiconductor device;

Fig. 2 is a view showing the distribution of pellet cracking load W1 in the conventional glass passivation semiconductor device;

Fig. 3 is a view showing the distribution of pellet cracking load W1 in a high voltage withstanding semiconductor device of beveled structure;

Fig. 4 is a view showing the distribution of pellet cracking load W1 in the conventional glass passivation semiconductor device in which glass cracks are caused;

Fig. 5 is a view showing the distribution of pellet cracking load W1 in the conventional glass passivation semiconductor device in which no glass cracks are caused;

Fig. 6 is a sectional view showing the other conventional glass passivation semiconductor device;

Fig. 7 is a graph showing the relation between the swell (d) of passivation glass and glass cracking load W2 in the conventional glass passivation semiconductor device;

Fig. 8 is a sectional view showing a glass passivation semiconductor device according to the present invention;

Fig. 9 is a graph showing the relation between the swell (d) of passivation glass and glass cracking load W2 in the glass passivation semiconductor device of the present invention; and

Fig. 10 is a view showing the distribution of pellet cracking load W1 in the glass passivation semiconductor device of the present invention.

There will be now described how glass or pellet cracks are caused in the conventional glass passivation semiconductor device before an embodiment of the present invention is described in detail.

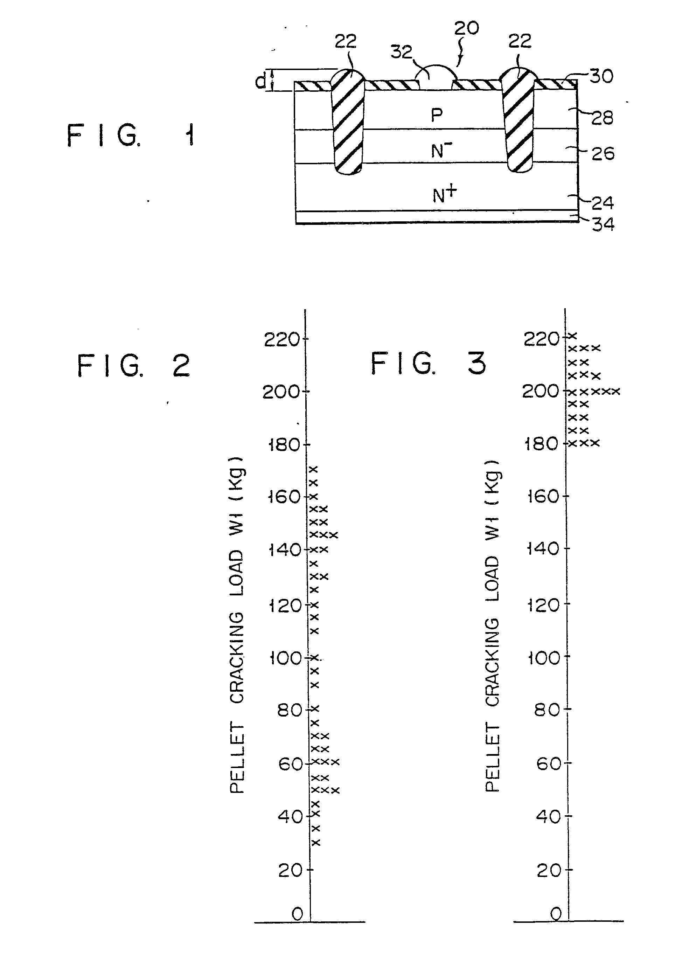

Fig. 1 shows a high voltage withstanding diode device 20 having glass passivation regions 22 and the diode device 20 will be hereinafter referred to as "a diode pellet". This diode pellet 20 comprises an $N^+$ layer 24, and $N^-$ layer 26 formed on the $N^+$ layer 24, a P-type region 28 formed on the $N^-$ layer 26, glass passivation regions 22 formed in recesses each having a depth which reaches the $N^+$ layer 24, a protection film 30 made of $SiO_2$ and formed on the P-type region 28 to stabilize the surface of semiconductor, an electrode 32 connected to the P-type region 28 and an electrode 34 connected to the $N^+$ layer 24. Recesses are formed by the chemical etching process or a diamond blade. Glass passivation regions 22 are formed by filling glass material in recesses according to the electrophoresis method, for example, and sintering the field glass material at the temperature of about 700°C.

The bending test was carried out using a plurality of diode pellets thus formed. Namely, leakage current in each of diode pellets was measured applying reverse bias to the PN junction of each of diode pellets and adding load to each of diode pellets. Load which causes short-circuited current or leakage current to flow was regarded as pellet cracking load W1, the short-circuited current being a current caused when the pellet itself cracks and the leakage current being larger current than initial leakage current generated when glass cracks are caused. Fig. 2 shows the result thus obtained. Fig. 3 also shows the result obtained by same measurements using pellets of beveled structure. As apparent from the comparison of Figs. 2 and 3, pellet cracking load W1 in the glass passivation semiconductor device is lower than that in the semiconductor device of beveled structure and dispersed in a wider range.

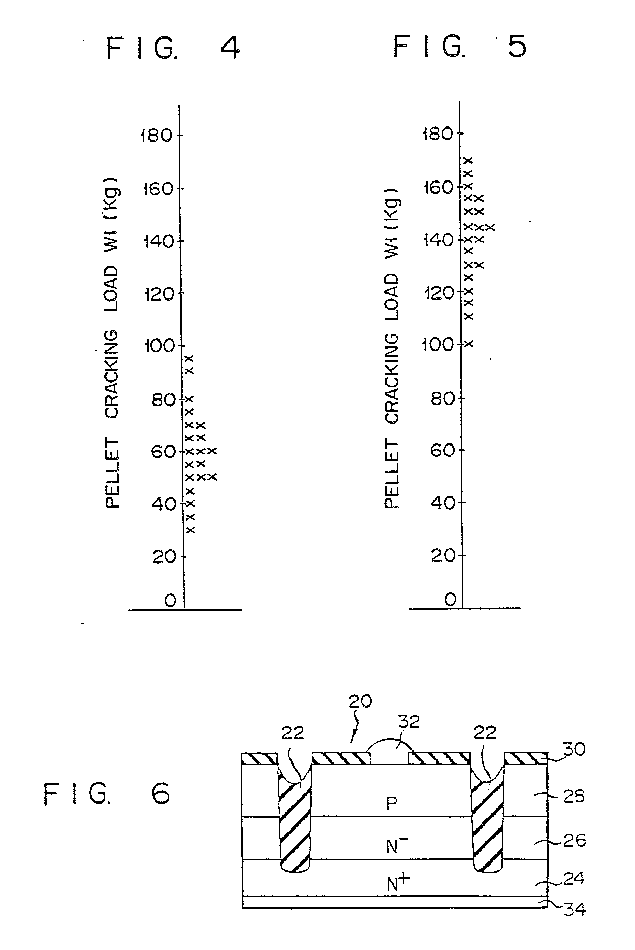

Fig. 4 shows the result of bending test carried out using diode pellets in which glass cracks are already caused before the bending test, and Fig. 5 also shows the result of bending test carried out using diode pellets in which no glass crack is caused before the bending test. It was found from these results that diode pellets in which pellet cracking load W1 is low had glass cracks caused before the bending test.

The reason why pellet cracking load W1 was dispersed in Fig. 5 will be now described. In order to examine whether the dispersion of pellet cracking load W1 is caused by the strength of glass itself or other matters, diode pellets were made using glass material of various glass strengths. The bending test was carried out using these diode pellets. Some little difference was found in the occurrence of glass cracks, but no large difference was found in pellet cracking load W1 after glass cracks were caused. It was guessed from this result that pellet cracks were generated by some other cause, namely, the shape of pellet. As the result of bending test of pellets having various passivation glass swells from the surface of semi-conductor substrate, it was recognized that the dispersion of pellet cracking load W1 depended upon the uneven shape of passivation glass.

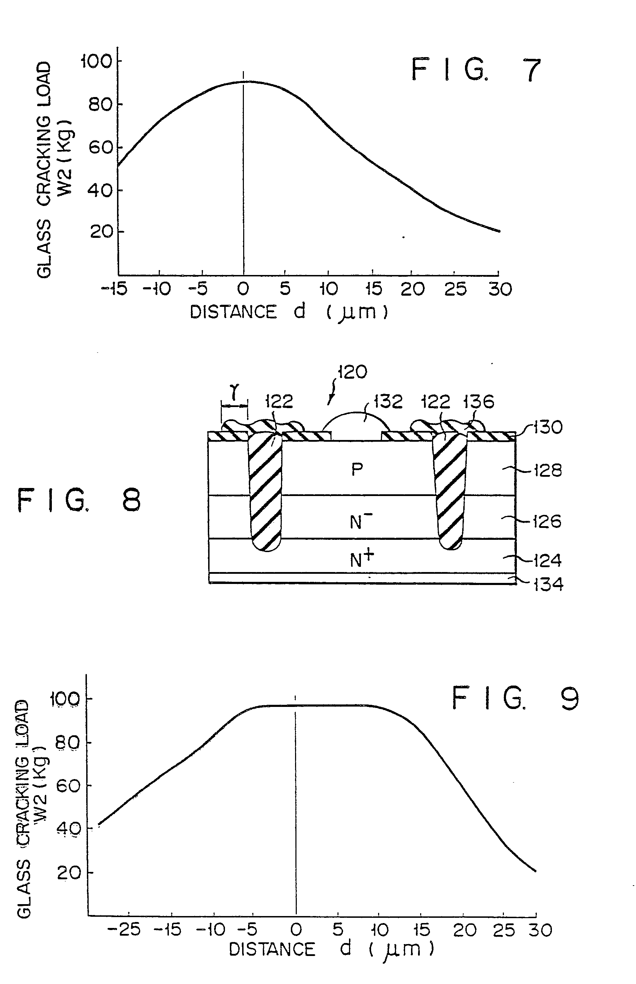

The following test was conducted to examine the relation between the uneven shape of passivation glass and the glass strength thereof. Diode pellets were made by variously changing voltage applied and the time period during which voltage was applied in the electrophoresis process to change the amount of glass filled and the swell (d) of passivation glass projected from the surface of semiconductor substrate. The bending test was then carried out adding load to these diode pellets. Fig. 7 is a graph showing the relation between the swell (d) of passivation glass and load W2 by which cracks are caused in passivation glass and which will be hereinafter referred to as "glass cracking load". The swell (d) is + (plus) when the surface of glass material is higher than the surface of semiconductor substrate and − (minus) when the former is lower than the latter. As apparent from Fig. 7, the strength of passivation glass is the largest when the surface of passivation glass is substantially same in level as the surface of semi-conductor substrate. The dispersion range (about 60 kg) of glass cracking load W2 in Fig. 7 is substantially equal to that (about 60 kg) of pellet cracking load W1 in Fig. 5. Further, pellet cracking load W1 becomes large as glass cracking load W2 becomes large. Because the pellet cracking load W1 is nearly equal to the sum of the glass cracking load W2 and a load for cracking the pellet in which the glass crack is caused.

It was recognized according to another test that no crack was caused in passivation glass during the manufacturing processes when glass cracking load W2 was larger than 80 kg. Pellet cracking load W1 of diode pellets having glass cracking load W2 larger than 80 kg was in the range of 150—190 kg in the bending test. When glass cracking load W2 was set larger than 80 kg like this, it could be recognized that the dispersion range of pellet cracking load W1 become small and that pellet cracking load W1 become large.

As apparent from Fig. 7, it is needed that the swell (d) of passivation glass is in the range of about ±7 μm for the purpose of making glass cracking load W2 larger than 80 kg. The distribution range of glass swell (d) formed by the glass filling and sintering process is usually ±5—6 μm under same manufacturing condition but practically becomes larger since the center in the distribution range of glass swell (d) is shifted. It is therefore extremely difficult to keep the swell (d) of passivation glass in the range of ±7 μm, thus reducing the yield of diode pellets.

It is needed, according to the conducted tests, that the strength of passivation glass is increased so as to enhance the strength of glass passivation semiconductor device. The strength of passivation glass depends upon the swell (d) of passivation glass. This means that internal stress present in passivation glass changes corresponding to the change of swell (d). This was the reason why the inventor of the present invention formed a stress relaxing layer on passivation glass to relax internal stress in passivation glass and to prevent cracks from being caused in passivation glass. It is needed that this layer functioning as a stress relaxing layer has an elastic modulus larger than that of passivation glass and can tightly contact relative to both passivation glass and protection film for stabilizing the surface of semiconductor substrate.

From this viewpoint, silicon oxide ($SiO_2$), boron-silicate glass (BSG) and phospho-silicate glass (PSG) were vapor-deposited respectively at low temperature on $SiO_2$ protection film and passivation glass according to CVD method. Phospho-silicate glass showed a remarkable stress relaxing effect. It was also found that the stress relaxing effect became higher as phospho-silicate glass had higher phosphorus concentration and that phospho-silicate glass was needed to have a layer thickness larger than 1 μm. It is needed that phospho-silicate glass tightly contacts with $SiO_2$ protection film at the end portion thereof.

An example of glass passivation semiconductor device according to the present invention will be now described referring to Fig. 8. Fig. 8 is a sectional view showing a diode pellet 120. An $N^-$ layer 126 is formed on an $N^+$-type semiconductor substrate 124. A P-type region 128 is formed thermally diffusing P-type impurity in the $N^-$ layer 126. A surface stabilizing protection film 130 consisting of $SiO_2$, for example, is then formed on the P-type region 128. Recesses each passing through the protection film 130, P-type region 128 and $N^-$ layer 126 and reaching the $N^+$-type semiconductor substrate 124 are formed by chemical etching or diamond blade. Passivation glass material is filled in recesses according to electrophoresis method. Glass material filled is sintered at temperature of 600°C—700°C to form glass passivation regions 122. Phospho-silicate glass is deposited on glass passivation regions 122 according to CVD method to form a stress relaxing layer 136. It is necessary that this chemical vapor deposition is carried out in an atmosphere lower than the sintering temperature of passivation glass, because passivation glass is so softened as to flow out of recesses or to have chemical change in an atmosphere higher than about 700°C. The stress relaxing layer 136 must have a thickness at least larger than 1 μm. When the thickness of layer 136 is smaller than 1 μm, the stress relaxing effect of passivation glass is negligible. In addition, it is preferable that the stress relaxing layer 136 is tightly contacted with $SiO_2$ protection film 130 with a width r at least larger than 30 μm so as to enhance the contact strength between the stress relaxing layer 136 and $SiO_2$ protection film 130.

$SiO_2$ film 130 is then selectively etched to form an opening in which an electrode 132 connected to P-type region 128 is formed. Another electrode 134 is also formed on the back face of $N^+$-type semiconductor substrate 124.

The stress relaxing layer 136 thus formed at a relatively low temperature is porous and it is guessed that the stress relaxing layer 136 is effective because it is porous.

The effect of glass passivation semiconductor device according to the present invention will be now described.

Passivation glass regions 122 each having a swell (d) different from those of other passivation glass regions are formed and the stress relaxing layer 136 is formed on passivation glass regions to have a thickness (d) of 1 μm and a width (r) of 30 μm. The bending test was carried out using diode pellets thus formed.

Fig. 9 shows the relation between the swell (d) at the passivation glass 122 and glass cracking load W2. According to the result shown in Fig. 9, the swell (d) of passivation glass may be made —10 μm — +15 μm in order to manufacture a diode pellet whose glass cracking load W2 is larger than 80 kg. As long as the swell (d) is in this range, the glass passivation semiconductor device can be manufactured according to the conventional glass filling technique.

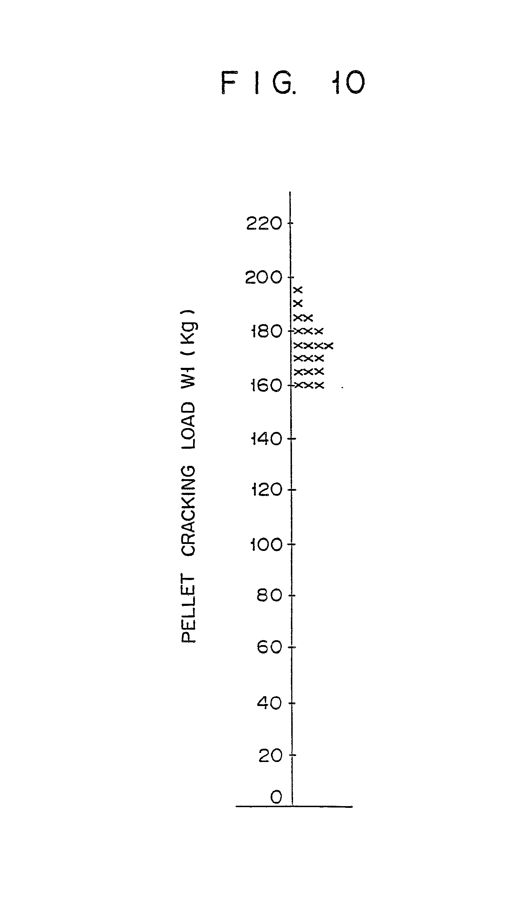

Fig. 10 shows the distribution of pellet cracking load W1 in the case of diode pellets formed according to the present invention. As apparent from Fig. 10, pellet cracking load is in the range of 160—195 kg. Diode pellets formed according to the present invention have a higher pellet strength as compared with that of conventional ones, and the dispersion of strength is small in diode pellets of the present invention. The ratio of occurrence of pellet or glass crack in pellet manufacturing and assembling processes was reduced to lower than 1—2%. The conventional ratio thereof was in the range of 50—60%.

The embodiment as described above is similar to the conventional mesa-type semiconductor device in which recesses to fill passivation glass therein are deepened. However, the present invention is not limited to the embodiment but applicable to the planar-type glass passivation semiconductor device, whose recesses are shallow, so as to achieve same effect. Therefore, the present invention is suitable for all of glass passivation semiconductor devices.

As described above, the present invention enables pellet strength to be made higher as compared with that of conventional glass passivation semiconductor devices and pellet strength obtained by the present invention becomes substantially equal to that of a high voltage withstanding semiconductor device of beveled structure in which no glass material is employed. Therefore, the present invention can prevent the yield from being reduced due to the occurrence of glass crack and provide a glass passivation semiconductor device suitable for mass production.

**Claims**

1. A glass passivation semiconductor device comprising

a PN junction region formed by first and second semiconductor regions (126, 128),

a passivation glass (122) directly formed on said PN junction region, and

a stress relaxing layer (136) formed on said passivation glass (122), characterized in that

a surface stabilizing protection film (130) covers at least one of said first and second semiconductor regions (126, 128), and

said stress relaxing layer (136) is tightly contacted with said protection film (130) so as to relax stress in said passivation glass (122).

2. A glass passivation semiconductor device according to claim 1, characterized in that said stress relaxing layer (136) consists of phosphosilicate glass.

3. A glass passivation semiconductor device according to claim 1 or 2, characterized in that said stress relaxing layer (136) has a thickness larger than 1 µm and a width (r) larger than 30 µm when measured outwardly from the outer circumference of said passivation glass (122).

4. A method of manufacturing a glass passivation semiconductor device comprising the steps of

forming a PN junction region in such a way that a first semiconductor region (126)

of a first conductivity type is contacted with a second semiconductor region (128) of a second conductivity type,

forming a recess which passes through said PN junction region, filling and sintering glass material in said recess to directly form glass (122) on said PN junction region, and

forming a stress relaxing layer (136) on said passivation glass (122), characterized in that

upon forming the PN junction region a surface stabilizing protection film (130) is formed, which covers at least one of said first and second semiconductor regions (126, 128) and

the stress relaxing layer (136) is formed on said passivation glass (122) in such a way that said stress relaxing layer (136) is tightly contacted with said protection film (130).

5. A method of manufacturing a glass passivation semiconductor device according to claim 4, characterized in that said stress relaxing layer (136) is chemically vapor-deposited in an atmosphere lower than 700°C.

**Patentansprüche**

1. Mit Glas passiviertes Halbleiterbauelement, umfassend

eine durch erste und zweite Halbleiterzonen (126, 128) gebildete PN-Übergangszone,

ein unmittelbar auf der PN-Übergangszone ausgebildetes passivierendes Glaselement (122) und

eine auf dem passivierenden Glaselement (122) ausgebildete Spannungsentlastungsschicht (136), dadurch gekennzeichnet, daß

ein Oberflächenstabilisierungs-Schutzfilm (130) zumindest eine der ersten und zweiten Halbleiterzonen (126, 128) bedeckt und

die Spannungsentlastungsschicht (136) in inniger Berührung mit dem Schutzfilm (130) steht und damit (mechanische) Spannung im passivierenden Glaselement (122) aufhebt.

2. Mit Glas passiviertes Halbleiterbauelement nach Anspruch 1, dadurch gekennzeichnet, daß die Spannungsentlastungsschicht (136) aus Phosphosilikatglas besteht.

3. Mit Glas passiviertes Halbleiterbauelement nach Anspruch 1 oder 2, dadurch gekennzeichnet, daß die Spannungsentlastungsschicht (136) eine Dicke von mehr als 1 µm und eine Breite (r) von mehr als 30 µm, vom Außenumfang des passivierenden Glaselements (122) nach außen gemessen, aufweist.

4. Verfahren zur Herstellung eines mit Glas passivierten Halbleiterbauelements, bei dem

eine PN-Übergangszone in der Weise ausgebildet wird, daß eine erste Halbleiterzone (126) eines ersten Leitfähigkeitstyps mit einer zweiten Halbleiterzone (128) eines zweiten Leitfähigkeitstyps in Kontakt steht,

eine durch die PN-Übergangszone verlaufende Ausnehmung ausgebildet, in die Ausnehmung ein Glasmaterial eingefüllt und dieses in der Ausnehmung gesintert wird, so daß ein Glaselement (122) unmittelbar auf der PN-Übergangszone erzeugt wird, und

auf dem passivierenden Glaselement (122) eine Spannungsentlastungsschicht (136) ausgebildet wird, dadurch gekennzeichnet, daß

bei der Ausbildung der PN-Übergangszone ein Oberflächenstabilisierungs-Schutzfilm (130) erzeugt wird, der zumindest eine der ersten und zweiten Halbleiterzonen (126, 128) bedeckt, und

die Spannungsentlastungsschicht (136) auf dem passivierenden Glaselement (122) so ausgebildet wird, daß die Spannungsentlastungsschicht (136) mit dem Schutzfilm (130) in inniger Berührung steht.

5. Verfahren zur Herstellung eines mit Glas passivierten Halbleiterbauelements nach Anspruch 4, dadurch gekennzeichnet, daß die Spannungsentlastungsschicht (136) in einer Atmosphäre (einer Temperatur) von unter 700°C chemisch aufgedampft wird.

**Revendications**

1. Un dispositif semi-conducteur à passivation au verre comportant:

une région de jonction PN formée par une première et une seconde régions semi-conductrices (126, 128),

un verre de passivation (122) formé directement sur ladite région de jonction PN, et

une couche (136) de relâchement des contraintes formée sur ledit verre de passivation (122), caractérisé en ce que

une pellicule protectrice de stabilisation de surface (130) couvre au moins l'une desdites première et seconde régions semi-conductrices (126, 128) et

ladite couche (136) de relâchement des contraintes est en contact étroit avec ladite pellicule de protection (130) de manière à relâcher les contraintes dans ledit verre de passivation (122).

2. Un dispositif semi-conducteur à passivation au verre selon la revendication 1, caractérisé en ce que ladite couche (136) de relâchement des contraintes consiste en un verre de phosphosilicate.

3. Un dispositif semi-conducteur à passivation au verre selon la revendication 1 ou 2, caractérisé en ce que ladite couche (136) de relâchement des contraintes présente une épaisseur supérieure à 1 µm et une largeur (r) supérieure à 30 µm, la mesure étant faite vers l'extérieur à partir de la circonférence extérieure dudit verre de passivation (122).

4. Un procédé pour fabriquer un dispositif semi-conducteur à passivation au verre comportant les étapes consistant à

former une région de jonction PN de telle manière qu'une première région semi-conductrice (126) d'un premier type de conductivité soit en contact avec une seconde région semi-conductrice (128) d'un second type de conductivité,

former une cavité qui traverse ladite région de jonction PN, verser et agglomérer la matière en verre dans ladite cavité pour former directement le verre (122) sur ladite région de jonction PN, et

former une couche (136) de relâchement des contraintes sur ledit verre de passivation (122), caractérisé en ce que

une pellicule de protection (130) de stabilisation de surface est formée lors de la réalisation de la région de jonction PN, cette pellicule couvrant au moins l'une desdites première et seconde régions semi-conductrices (126, 128) et

la couche (136) de relâchement des contraintes est formée sur ledit verre de passivation (122) de telle manière que ladite couche (136) de relâchement des contraintes soit en contact étroit avec ladite pellicule de protection (130).

5. Un procédé pour fabriquer un dispositif semi-conducteur à passivation au verre selon la revendication 4, caractérisé en ce que ladite couche (136) de relâchement des contraintes est déposée chimiquement à la vapeur dans une atmosphère inférieure à 700°C.

F I G. 1

F I G. 2

F I G. 3

PELLET CRACKING LOAD W1 ( Kg )

PELLET CRACKING LOAD W1 ( Kg )

FIG. 4    FIG. 5

FIG. 6

F I G. 7

F I G. 8

F I G. 9

# F I G. 10